(19) Europäisches Patentamt
European Patent Office
Office européen des brevets

(11) **EP 4 752 974 A1**

(12) **EUROPEAN PATENT APPLICATION**
published in accordance with Art. 153(4) EPC

(43) Date of publication:
**03.06.2026 Bulletin 2026/23**

(21) Application number: **24868608.1**

(22) Date of filing: **12.09.2024**

(51) International Patent Classification (IPC):
$H01M\ 4/525$ [(2010.01)]     $H01M\ 4/62$ [(2006.01)]
$H01M\ 10/052$ [(2010.01)]     $C30B\ 29/22$ [(2006.01)]
$C01G\ 53/00$ [(2025.01)]     $H01M\ 4/02$ [(2006.01)]

(52) Cooperative Patent Classification (CPC):
C01G 53/00; C30B 29/22; H01M 4/02; H01M 4/505;
H01M 4/525; H01M 4/62; H01M 10/052;
Y02E 60/10

(86) International application number:
**PCT/KR2024/013941**

(87) International publication number:
**WO 2025/063631 (27.03.2025 Gazette 2025/13)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **19.09.2023 KR 20230124865**

(71) Applicant: **LG Energy Solution, Ltd.**
**Seoul 07335 (KR)**

(72) Inventors:
• **BAEK, So Ra**
**Daejeon 34122 (KR)**

• **CHO, Hyeon Jin**
**Daejeon 34122 (KR)**
• **YOO, Dong Wan**
**Daejeon 34122 (KR)**
• **HAN, Jung Hoon**
**Daejeon 34122 (KR)**
• **JO, Chi Ho**
**Daejeon 34122 (KR)**
• **RYU, Ho Hyeon**
**Daejeon 34122 (KR)**
• **PARK, Byung Chun**
**Daejeon 34122 (KR)**

(74) Representative: **Hoffmann Eitle**
**Patent- und Rechtsanwälte PartmbB**
**Arabellastraße 30**
**81925 München (DE)**

(54) **POSITIVE ELECTRODE MATERIAL POWDER, METHOD FOR MANUFACTURING SAME, AND LITHIUM SECONDARY BATTERY COMPRISING SAME**

(57)     The present invention provides a positive electrode material powder containing particles of a lithium nickel-based oxide represented by chemical formula 1 and having a single crystallinity of 1.85 to 3.00 as expressed by equation (1) according to the present invention. [Chemical formula 1] $Li_aNi_bCo_cM^1_dM^2_eO_2$ In chemical formula 1, $M^1$ is Mn, Al, or a combination thereof, $M^2$ is at least one selected from the group consisting of Ti, Mg, Al, Zr, Y, Ba, Ca, Sr, W, Ta, Nb, and Mo, $0.80 \le a \le 1.20$, $0.80 \le b < 1$, $0 < c < 0.45$, $0 < d < 0.45$, and $0 \le e \le 0.20$.

FIG. 4

EP 4 752 974 A1

Description

**TECHNICAL FIELD**

**Cross-reference to Related Applications**

This application claims the benefit of Korean Patent Application No. 10-2023-0124865, filed on September 19, 2023, the application of which is incorporated herein in its entirety by reference.

**Technical Field**

The present invention relates to positive electrode material powder, a method for preparing the same, and a lithium secondary battery including the same. More specifically, the present invention relates to positive electrode material powder capable of improving high-temperature properties, a method for preparing the same, and a lithium secondary battery including the same.

**BACKGROUND ART**

A lithium secondary battery is generally composed of a positive electrode, a negative electrode, a separator, and an electrolyte, and the positive electrode and the negative electrode include active materials capable of intercalation and deintercalation of lithium ions.

As a positive electrode active material of the lithium secondary battery, a lithium cobalt oxide ($LiCoO_2$), a lithium nickel oxide ($LiNiO_2$), a lithium manganese oxide ($LiMnO_2$, $LiMnO_4$, or the like), a lithium iron phosphate compound ($LiFePO_4$), and the like have been used. Among the above, the lithium cobalt oxide is advantageous in that the driving voltage is high and the capacity properties are excellent, but since the price of cobalt, which is a raw material, is high, and the supply thereof is unstable, it is difficult to commercially apply the lithium cobalt oxide to a large-capacity battery. The lithium nickel oxide has poor structural stability, so that it is difficult to implement sufficient lifespan properties. Meanwhile, the lithium manganese oxide has excellent stability, but has a problem in that the capacity properties thereof are poor. Therefore, in order to compensate for problems of lithium transition metal oxides including Ni, Co, or Mn alone, lithium composite transition metal oxides including two or more transition metals have been developed, and among them, a lithium nickel cobalt manganese oxide including Ni, Co, and Mn is widely used in the field of electric vehicle batteries.

A typical lithium nickel cobalt manganese oxide is generally in the form of a spherical secondary particle in which tens to hundreds of primary particles are aggregated. However, in the case of applying a lithium nickel cobalt manganese oxide in the form of a secondary particle in which a large number of primary particles are aggregated, particle breakage easily occurs wherein primary particles are broken off during a roll-pressing process when manufacturing a positive electrode, and there is a problem in that cracks are generated inside particles during a charging and discharging process. When particles of a positive electrode active material are broken or cracked, the contact area with an electrolyte solution increases, so that gas generation and active material deterioration caused by a side reaction with the electrolyte solution increase, resulting in a problem in that lifespan properties are degraded.

Meanwhile, the demand for high-power and high-capacity batteries, such as batteries for electric vehicles, has been increasing in recent years, and accordingly, there is a trend toward increasing electrode density to manufacture a high-capacity battery. However, if the electrode density is increased, capacity properties are improved, but the generation of fine powder due to particle breakage during the roll-pressing of an electrode increases, and accordingly, the reaction area with an electrolyte solution increases, so that there is a disadvantage in that the electrolyte solution is decomposed during charge and discharge and the surface structure of an active material is deteriorated.

In order to solve the above-described problem, a technique for preparing a positive electrode active material in the form of a single particle rather than a secondary particle by increasing a firing temperature when preparing a lithium nickel cobalt manganese oxide has been proposed. A positive electrode active material in the form of a single particle has a smaller contact area with an electrolyte solution compared to a typical positive electrode active material in the form of a secondary particle, and thus, has fewer side reactions with the electrolyte solution. Therefore, when a positive electrode active material in the form of a single particle is applied, there are advantages in that there is less gas generation, and lifespan properties are excellent.

However, a typical positive electrode active material in the form of a single particle has a problem in that a large amount of gas is generated at high temperatures or lifespan properties are poor.

**DISCLOSURE OF THE INVENTION**

## TECHNICAL PROBLEM

In order to solve the above problem, an aspect of the present invention provides positive electrode material powder having less gas generation at high temperatures and excellent lifespan properties, a method for preparing the same, and a lithium secondary battery including the same.

## TECHNICAL SOLUTION

[1] The present invention provides positive electrode material powder including lithium nickel-based oxide particles represented by Formula 1 below, and having a single crystallinity of 1.85 to 3.00 represented by Equation (1) below.

[Formula 1]          $Li_aNi_bCo_cM^1_dM^2_eO_2$

In Formula 1 above, $M^1$ is Mn, Al, or a combination thereof, $M^2$ is one or more selected from the group consisting of Ti, Mg, Al, Zr, Y, Ba, Ca, Sr, W, Ta, Nb, and Mo, and $0.80 \le a \le 1.20$, $0.80 \le b < 1$, $0 < c < 0.45$, $0 < d < 0.45$, and $0 \le e \le 0.20$.

$$\text{Equation (1): Single crystallinity} = \frac{\sum_{k=1}^{n} A_k^2}{\sum_{k=1}^{n} A_k}$$

In Equation (1) above, $A_k$ is the area of a k-th grain as measured by ion-milling an electrode manufactured by applying the positive electrode material powder, and then analyzing a cross-section of the electrode by electron backscatter diffraction (EBSD), and n is the total number of grains as measured by the electron backscatter diffraction (EBSD) analysis, which is 200 to 500.

[2] In [1] above, Formula 1 above may be represented by Formula 1-1 below.

[Formula 1-1]          $Li_{a1}Ni_{b1}Co_{c1}Mn_{d1}Al_{d2}M^2_{e1}O_2$

In Formula 1-1 above, $M^2$ may be one or more selected from the group consisting of Ti, Mg, Al, Zr, Y, Ba, Ca, Sr, W, Ta, Nb, and Mo, and it may be that $0.80 \le a1 \le 1.20$, $0.85 \le b1 < 1$, $0 < c1 < 0.45$, $0 < d1 < 0.18$, $0 < d2 < 0.15$, $0 \le e1 \le 0.20$, and $0 < d1+d2 < 0.33$.

[3] In [1] or [2] above, the positive electrode material powder may have a specific surface area of 0.40 $m^2$/g to 0.75 $m^2$/g.

[4] In at least one among [1] to [3] above, the positive electrode material powder may have a roll-pressing density of 2.9 g/cc to 3.2 g/cc.

[5] In at least one among [1] to [4] above, when the positive electrode material powder is pressed at 9 ton, the rate of generation of fine powder of 1 $\mu$m or less may be 6 vol% or less.

[6] In at least one among [1] to [5] above, the positive electrode material powder may have an average particle diameter ($D_{50}$) of 2 $\mu$m to 5 $\mu$m.

[7] In at least one among [1] to [6] above, the positive electrode material powder has a single crystallinity of 2.0 to 2.5 represented by Equation (1).

[8] The present invention provides a method for preparing the positive electrode material powder according to at least one among [1] to [7] above, the method including (S1) mixing a positive electrode active material precursor and a lithium source, and then performing primary firing on the mixture, and (S2) performing secondary firing on a fired product obtained by the primary firing, wherein the primary firing is performed at 850 °C to 960 °C for 10 hours to 20 hours, the secondary firing sequentially includes a first maintaining period maintained at 720 °C to 850 °C, a second maintaining period maintained at 900 °C to 970 °C, and a third maintaining period maintained at 720 °C to 850 °C, and the positive electrode active material precursor has a nickel content of 80 mol% or greater among all metals excluding lithium.

[9] In [8] above, the primary firing may be performed at 870 °C to 960 °C for 10 hours to 15 hours.

[10] In [8] or [9] above, the first maintaining period and the third maintaining period may independently be maintained for 5 hours to 10 hours.

[11] In at least one among [8] to [10] above, the second maintaining period may be maintained for 5 minutes to 60 minutes.

[12] In at least one among [8] to [11] above, the total firing time of the secondary firing may be 10 hours to 15 hours.

[13] The present invention provides a lithium secondary battery including a positive electrode containing the positive electrode material powder of at least one among [1] to [7] above, a negative electrode, a separator, and an electrolyte.

## ADVANTAGEOUS EFFECTS

Positive electrode material powder according to the present invention is characterized by having a single crystallinity satisfying a range of 1.85 to 3.00 represented by Equation (1). In the case of a lithium secondary battery to which positive electrode material powder having a single crystallinity of less than 1.85 or greater than 3.00 represented by Equation (1) is applied, the amount of gas generated during high-temperature storage is large, and high-temperature lifespan properties are degraded.

On the other hand, in the case of a lithium secondary battery to which positive electrode material powder having a single crystallinity satisfying the above-described range of the present invention is applied, both high-temperature lifespan properties and high-temperature storage properties are excellent.

## BEST DESCRIPTION OF THE DRAWING

FIG. 1 is a SEM image of a cross-section of an electrode manufactured using positive electrode material powder prepared in Example 1 of the present invention.

FIG. 2 is a SEM image of a cross-section of an electrode manufactured using positive electrode material powder prepared in Example 2 of the present invention.

FIG. 3 is a SEM image of a cross-section of an electrode manufactured using positive electrode material powder prepared in Comparative Example 2 of the present invention.

FIG. 4 is a SEM image of a cross-section of an electrode manufactured using the positive electrode material powder prepared in Example 1 of the present invention, and is an image obtained by performing EBSD analysis.

FIG. 5 is a SEM image of a cross-section of an electrode manufactured using the positive electrode material powder prepared in Example 2 of the present invention, and is an image obtained by performing EBSD analysis.

FIG. 6 is a SEM image of a cross-section of an electrode manufactured using the positive electrode material powder prepared in Comparative Example 2 of the present invention, and is an image obtained by performing EBSD analysis.

## MDOE FOR CARRYING OUT THE INVENTION

Hereinafter, the present invention will be described in more detail.

It will be understood that terms or words used in the present specification and claims shall not be construed as being limited to having meanings defined in commonly used dictionaries, but should be interpreted as having meanings and concepts consistent with the technical idea of the present invention based on the principle that an inventor may appropriately define concepts of the terms to best explain the invention.

In the present invention, a "grain" is a particle unit having the same crystal orientation, and is a minimum particle unit recognized as a single mass in an electron backscatter diffraction (EBSD) map image. The size of a grain may be measured by analyzing an EBSD map.

In the present invention, a "single particle" refers to a particle composed of one nodule, and a "pseudo-single particle" refers to a composite particle of 30 nodules or fewer.

The "nodule" is a sub-particle unit constituting a single particle and a pseudo-single particle, and may be a single crystal with no crystalline grain boundaries, or a polycrystal with no grain boundaries in appearance when observed with a field of view of 5000 to 20000 times using a scanning electron microscope.

In the present invention, a "secondary particle" refers to a particle formed by the agglomeration of a plurality of, for example, tens to hundreds of primary particles. Specifically, the secondary particle may be an agglomerate of 50 or more primary particles.

In the present invention, the "particle" is a concept including any one or all of a single particle, a pseudo-single particle, a primary particle, a nodule, and a secondary particle.

In the present invention, a "specific surface area" is measured by a BET method, and specifically, may be calculated from the adsorption amount of nitrogen gas under a liquid nitrogen temperature (77K) using Belsorp-mini II of BEL Japan Co., Ltd.

In the present invention, an "average particle diameter $D_{50}$" refers to a particle size based on 50% of a volume cumulative particle size distribution of positive electrode material powder, and may be measured using a laser diffraction method. For example, the average particle diameter $D_{50}$ may be measured by dispersing the positive electrode material powder in a dispersion medium, and then introducing the mixture into a commercially available laser diffraction particle size measurement device (e.g., Microtrac MT 3000) to be irradiated with an ultrasonic wave of about 28 kHz to an output of 60 W, thereby obtaining a volume cumulative particle size distribution graph, and then obtaining a particle size corresponding to 50% of a cumulative volume.

As a result of repeated research to develop a positive electrode material with excellent high-temperature properties, the present inventors have found that if the ratio of the sum of the squares of grain areas of positive electrode material powder to the sum of the grain areas thereof satisfies a specific relationship, excellent high-temperature properties may be implemented, and have completed the present invention.

Hereinafter, the present invention will be described in detail.

Positive electrode material powder, a method for preparing the same, and a lithium secondary battery including the same according to the present invention include at least one among configurations disclosed below, and may include any combination of technically possible configurations among the following configurations.

**Positive electrode material powder**

Hereinafter, the positive electrode material powder according to the present invention will be described.

The positive electrode material powder according to the present invention has a single crystallinity of 1.85 to 3.00 represented by Equation (1) below.

$$\text{Equation (1): Single crystallinity} = \frac{\sum_{k=1}^{n} A_k^2}{\sum_{k=1}^{n} A_k}$$

In Equation (1) above, $A_k$ is the area of a k-th grain as measured by ion-milling an electrode manufactured by applying the positive electrode material powder, and then analyzing a cross-section of the electrode by electron backscatter diffraction (EBSD), and is value measured in a unit of $\mu m^2$. Specifically, the value of the $A_k$ may be obtained through software of an EBSD device. In addition, the $A_k^2$ is the square of the $A_x$ obtained by the above-described method, and refers to the square of the area of a k-th grain.

Meanwhile, the $A_k$ and $A_k^2$ substituted into Equation (1) are dimensionless numbers that do not include a unit.

The n is the total number of grains measured through the electron backscatter diffraction (EBSD) analysis, and may be 200 to 500, preferably 250 to 450, and more preferably 300 to 400. If the total number of the grains measured is too small, it is not representative of the tendency of a grain size in the entire positive electrode material powder, and if too large, the measurement accuracy may be lowered.

The electron backscatter diffraction (EBSD) analysis is a method of measuring a crystallographic phase and a crystallographic orientation by using a diffraction pattern of a sample, and analyzing crystallographic information of the sample on the basis of the measurements. If the sample is tilted to have a large angle with respect to an incident direction of an electron beam in a scanning electron microscope, the incident electron beam is scattered in the sample, thereby allowing the diffraction pattern to appear in a surface direction of the sample, which is referred to as an electron backscattered diffraction pattern (EBSP). The electron backscattered diffraction pattern responds to a crystallographic orientation of a region on which the electron beam is irradiated, and thus, may be used to accurately measure the crystallographic orientation of the sample, and to obtain an EBSD inverse pole figure (IPF) map partitioned for each grain with the same crystallographic orientation. In addition, the EBSD software may be used to image-analyze the IPF map, thereby obtaining information such as grain size, shape, and orientation.

In the present invention, for EBSD analysis of positive electrode material powder, an electrode for EBSD analysis is manufactured using positive electrode material powder to be analyzed, and the manufactured electrode is cut by ion milling, and then an electron beam is irradiated on a cross-section of the cut electrode to perform the EBSD analysis. Specifically, the electrode for EBSD measurement may be manufactured by mixing the positive electrode material powder to be analyzed, a conductive material, and a binder in N-methyl pyrrolidone to prepare an electrode slurry, and applying the electrode slurry on an aluminum current collector, followed by drying the same. Meanwhile, when manufacturing the electrode for EBSD analysis, a roll-pressing process is not performed. This is because if a roll-pressing process is performed, positive electrode active material particles may be deformed or broken.

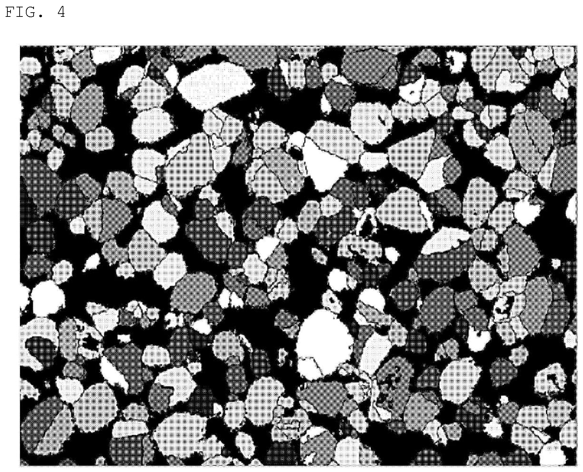

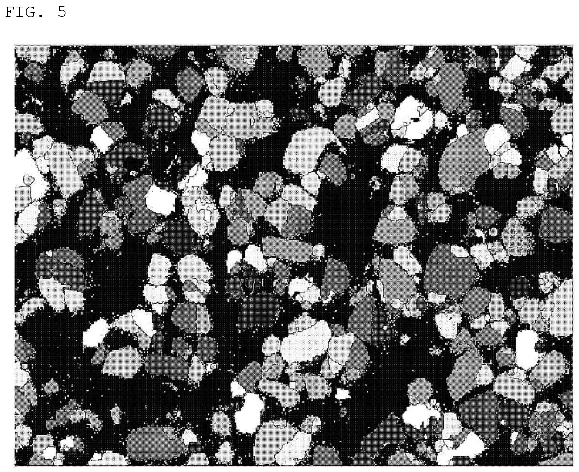

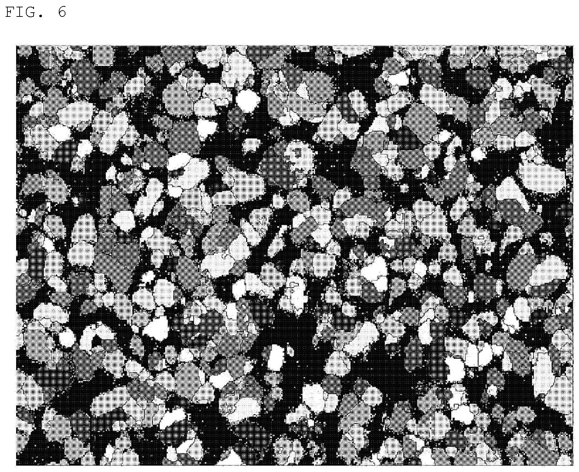

FIG. 4 to FIG. 6 illustrate IPF map images obtained by cutting electrodes manufactured using positive electrode material powder of Examples 1 to 2 and Comparative Example 2 to be described later, and then performing EBSD analysis on cross-sections of the electrodes. As shown in FIG. 4 to FIG. 6, the EBSD analysis may be used to obtain images partitioned for each grain unit.

According to the research of the present inventors, if a single crystallinity represented by Equation (1) above satisfies a specific range, it is possible to obtain an effect of simultaneously improving high-temperature storage and high-temperature lifespan properties.

The single crystallinity represented by Equation (1) above is 1.85 to 3.00. The single crystallinity may preferably be 1.9 to 2.8, and may more preferably be 2.0 to 2.5. Equation (1) above is obtained by dividing the sum of squares of the area of grains which appear at the time of EBSD analysis by the sum of the area of the grains, and if Equation (1) above is less than 1.85, the area of a reaction of positive electrode material powder which reacts with an electrolyte solution increases, thereby accelerating electrolyte solution decomposition and surface structure deterioration, so that there is a problem in that high-temperature storage properties and lifespan properties are degraded, and if Equation (1) above is greater than 3.00, the distance of movement by which lithium ions diffuse into particles increases, thereby deteriorating lithium mobility, and accordingly, there is lithium ion imbalance between the inside and outside of the particles during charge/discharge, so that there is a problem in that high-temperature storage properties and lifespan properties are degraded. Therefore, it has been found that if a lithium secondary battery is manufactured by applying positive electrode material powder which satisfies the above-described range, both high-temperature storage properties and high-temperature lifespan properties are excellent.

The single crystallinity represented by Equation (1) above may be controlled by various methods, but may preferably be controlled according to the number of moles of nickel contained in lithium nickel-based oxide particles, and the type, mixing ratio, firing step, firing temperature, firing time, firing atmosphere, and the like of raw materials used when preparing positive electrode material powder.

Meanwhile, the positive electrode material powder according to the present invention includes lithium nickel-based oxide particles represented by [Formula 1] below.

$$\text{[Formula 1]} \qquad Li_aNi_bCo_cM^1{}_dM^2{}_eO_2$$

In [Formula 1] above, The $M^1$ is Mn, Al, or a combination thereof, preferably Mn, or a combination of Mn and Al, or more preferably a combination of Mn and Al.

The $M^2$ is one or more selected from the group consisting of Ti, Mg, Al, Zr, Y, Ba, Ca, Sr, W, Ta, Nb, and Mo, preferably one or more selected from the group consisting of Ti, Mg, Al, Zr, Y, Sr, W, and Nb, and more preferably one or more selected from the group consisting of Ti, Mg, Al, Zr, and Y. An $M^2$ element is not necessarily included, but if included in an appropriate amount, the $M^2$ element may serve to promote particle growth during firing or to improve crystal structure stability.

The a represents the molar ratio of lithium in the lithium nickel-based oxide particle, and may satisfy $0.80 \leq a \leq 1.20$, $0.90 \leq a \leq 1.10$, or $0.95 \leq a \leq 1.15$. When the molar ratio of lithium satisfies the above-described range, a stable layered crystal structure may be formed.

The b represents the molar ratio of nickel among all metals excluding lithium in the lithium nickel-based oxide particle, and may satisfy $0.80 \leq b < 1$, $0.82 \leq b < 1$, or $0.85 \leq b < 1$. If the molar ratio of nickel satisfies the above-described range, capacity properties are exhibited excellent, and particularly, if the molar ratio of nickel is 0.80 or greater, it is possible to implement even more excellent capacity properties, and if the molar ratio of nickel is less than 0.80, there is a problem in that it is difficult to implement the single crystallinity represented by Equation (1) above.

The c represents the molar ratio of cobalt among all metals excluding lithium in the lithium nickel-based oxide particle, and may satisfy $0 < c < 0.45$, $0 < c < 0.40$, $0 < c < 0.20$, or $0 < c < 0.18$.

The d represents the molar ratio of an $M^1$ element among all metals excluding lithium in the lithium nickel-based oxide particle, and may satisfy $0 < d < 0.45$, $0 < d < 0.40$, $0 < d < 0.33$, $0 < d < 0.25$, $0 < d < 0.20$, or $0 < d < 0.18$.

The e represents the molar ratio of the $M^2$ element among all metals excluding lithium in the lithium nickel-based oxide particle, and may satisfy $0 \leq e \leq 0.20$, $0 \leq e \leq 0.15$, or $0 \leq e \leq 0.10$.

More preferably, [Formula 1] above may be represented by [Formula 1-1] below.

$$\text{[Formula 1-1]} \qquad Li_{a1}Ni_{b1}Co_{c1}Mn_{d1}Al_{d2}M^2{}_{e1}O_2$$

In [Formula 1-1] above, the $M^2$ may be one or more selected from the group consisting of Ti, Mg, Al, Zr, Y, Ba, Ca, Sr, W, Ta, Nb, and Mo, and it may be that $0.80 \leq a1 \leq 1.20$, $0.80 \leq b1 < 1$, $0 < c1 < 0.18$, $0 < d1 < 0.18$, $0 < d2 < 0.15$, $0 \leq e1 \leq 0.20$, and $0 < d1 + d2 < 0.33$, preferably, $0.80 \leq a1 \leq 1.20$, $0.82 \leq b1 < 1$, $0 < c1 < 0.15$, $0 < d1 < 0.15$, $0 < d2 < 0.10$, $0 \leq e1 \leq 0.10$, and $0 < d1 + d2 < 0.25$, and more preferably, $0.80 \leq a1 \leq 1.20$, $0.85 \leq b1 < 1$, $0 < c1 < 0.15$, $0 < d1 < 0.15$, $0 < d2 < 0.10$, and $0 \leq e1 \leq 0.10$, $0 < d1 + d2 < 0.25$. If the lithium nickel-based oxide particle has the composition of [Formula 1-1], the structural stability and capacity properties of a positive electrode active material are exhibited excellent.

Meanwhile, the positive electrode material powder may further include a coating layer containing one or more coating elements selected from the group consisting of Al, Ti, W, B, F, P, Mg, Ni, Co, Fe, Cr, V, Cu, Ca, Zn, Zr, Nb, Mo, Sr, Sb, Bi, Si, and S, formed on the surface of the lithium nickel-based oxide particle.

If there is a coating layer present on the surface of the lithium nickel-based oxide particle, the contact between an electrolyte and the lithium nickel-based oxide particle is suppressed by the coating layer, and as a result, there may be an effect of reducing transition metal elution or gas generation due to a side reaction with the electrolyte.

Meanwhile, the lithium nickel-based oxide particle may be in the form of a single particle composed of one nodule and/or a pseudo-single particle, which is a composite of 30 nodules or fewer, preferably 2 nodules to 20 nodules, more preferably 2 nodules to 10 nodules, or may be in the form including the same. Preferably, the positive electrode material powder according to the present invention may be composed of a combination of positive electrode active material particles in the form of a single particle and a pseudo-single particle. This is because if the number of nodules constituting the positive electrode active material particles is greater than 30, particle breakage increases during electrode manufacturing, and internal cracking increases due to volume expansion/contraction of nodules during charge and discharge, so that the effect of improving high-temperature lifespan properties and high-temperature storage properties may be degraded.

Meanwhile, the positive electrode material powder may have a specific surface area of 0.40 $m^2$/g to 0.75 $m^2$/g, preferably 0.45 $m^2$/g to 0.70 $m^2$/g, and more preferably 0.50 $m^2$/g to 0.70 $m^2$/g. If the above-described BET specific surface area range is satisfied, a side reaction with an electrolyte solution may be appropriately reduced to reduce gas generation, and high-temperature lifespan performance of a battery may be improved.

Meanwhile, the positive electrode material powder may have a roll-pressing density of 2.9 g/cc to 3.2 g/cc, preferably 2.95 g/cc to 3.1 g/cc. If the above-described roll-pressing density of the positive electrode material powder is satisfied, an excellent energy density may be secured, and particle breakage occurring during electrode roll-pressing may be prevented to appropriately reduced a side reaction with an electrolyte solution, so that lifespan of a battery, and stability properties may be improved.

Meanwhile, when the positive electrode material powder is pressed at 9 ton, the rate of generation of fine powder of 1 $\mu$m or less may be 6 vol% or less, preferably, the rate of generation of fine powder of 1 $\mu$m or less may be 5 vol% or less, and more preferably, the rate of generation of fine powder of 1 $\mu$m or less may be 3 vol% or less. Since a surface side reaction of a positive electrode active material is mainly caused by the generation of fine powder of the positive electrode active material, if a large amount of fine powder of 1 $\mu$m or less is generated, a side reaction with an electrolyte solution may be intensified, so that lifespan properties and storage properties at high temperatures may be degraded.

Meanwhile, the positive electrode material powder may have an average particle diameter ($D_{50}$) of 2 $\mu$m to 5 $\mu$m, preferably 2.5 $\mu$m to 4.5 $\mu$m, more preferably 3 $\mu$m to 4 $\mu$m, and even more preferably 3.3 $\mu$m to 3.7 $\mu$m. The average particle diameter ($D_{50}$) of the positive electrode material powder is a particle size when a cumulative volume appearing in a volume cumulative particle size distribution measured using a laser diffraction method is 50%. In this case, if the average particle diameter ($D_{50}$) of the positive electrode material powder satisfies the above-described range, the initial capacity of a battery, and output properties may be excellent.

## Method for preparing positive electrode material powder

Next, the method for preparing the positive electrode material powder according to the present invention will be described.

The method for preparing the positive electrode material powder according to the present invention includes (S1) mixing a positive electrode active material precursor and a lithium source, and then performing primary firing on the mixture, and (S2) performing secondary firing on a fired product obtained by the primary firing, wherein the primary firing is performed at 850 °C to 960 °C for 10 hours to 20 hours, the secondary firing sequentially includes a first maintaining period maintained at 720 °C to 850 °C, a second maintaining period maintained at 900 °C to 970 °C, and a third maintaining period maintained at 720 °C to 850 °C, and the positive electrode active material precursor has a nickel content of 80 mol% or greater among all metals excluding lithium.

The positive electrode material powder according to the present invention described above may be prepared by appropriately controlling the type, mixing ratio, firing step, firing temperature, firing atmosphere, and the like of raw materials.

Hereinafter, each step of the present invention will be described in detail.

(Step S1)

This is a step of mixing a positive electrode active material precursor and a lithium source, and then performing primary firing on the mixture, and the primary firing is performed at 850 °C to 960 °C for 10 hours to 20 hours.

The positive electrode active material precursor has a nickel content of 80 mol% or greater among all metals excluding lithium. Preferably, the content of nickel among all metals excluding lithium may be 82 mol% or greater, and more preferably, the content of nickel among all metals excluding lithium may be 85 mol% or greater. If the content of nickel among all metals excluding lithium in the positive electrode active material precursor is less than 80 mol%, as the content of nickel decreases, or the content of other elements increases, a large amount of heat is required to secure crystallinity, and accordingly, thus a high firing temperature is essential in order to increase single crystallinity. Therefore, if the content of nickel among all metals excluding lithium in the positive electrode active material precursor is less than 80 mol%, in a firing temperature range according to the present invention, it is difficult to control the single crystallinity represented by Equation (1) to be in the above-described range, and even if the primary firing and the secondary firing according to the present invention are performed to prepare positive electrode active material powder, there is a problem in that it is difficult to implement excellent high-temperature storage properties and lifespan properties.

In addition, the positive electrode active material precursor may be a commercially available precursor purchased and used, such as a nickel-cobalt-manganese-based hydroxide, nickel-cobalt-manganese-aluminum-based hydroxide, or the like, or may be prepared according to a precursor preparation method known in the art, such as coprecipitation.

For example, a transition metal-containing solution including cations of nickel (Ni), cobalt (Co), and manganese (Mn) is prepared, and then the transition metal-containing solution is added with an ammonium cation-containing complex forming agent and a basic aqueous solution to be subjected to a coprecipitation reaction to prepare a positive electrode active material precursor, and if necessary, the transition metal-containing solution may further include cations of aluminum (Al).

The transition metal-containing solution may include a nickel-containing raw material, a cobalt-containing raw material, and a manganese-containing raw material, and if necessary, may further include an aluminum-containing raw material.

The nickel-containing raw material may be, for example, an acetate, a nitrate, a sulfate, a halide, a sulfide, a hydroxide, an oxide, an oxyhydroxide, or the like, which contains nickel, and may be, specifically, $Ni(OH)_2$, $NiO$, $NiOOH$, $NiCO_3 \cdot 2Ni(OH)_2 \cdot 4H_2O$, $NiC_2O_2 \cdot 2H_2O$, $Ni(NO_3)_2 \cdot 6H_2O$, $NiSO_4$, $NiSO_4 \cdot 6H_2O$, a fatty acid nickel salt, a nickel halide, or a combination thereof, but is not limited thereto.

The cobalt-containing raw material may be an acetate, a nitrate, a sulfate, a halide, a sulfide, a hydroxide, an oxide, or an oxyhydroxide, and the like, all containing cobalt, specifically $Co(OH)_2$, $CoOOH$, $Co(OCOCH_3)_2 \cdot 4H_2O$, $Co(NO_3)_2 \cdot 6H_2O$, $CoSO_4$, $Co(SO_4)_2 \cdot 7H_2O$, or a combination thereof, but is not limited thereto.

The manganese-containing raw material may be, for example, an acetate, a nitrate, a sulfate, a halide, a sulfide, a hydroxide, an oxide, an oxyhydroxide, or a combination thereof, which contains manganese, and may be, specifically, a manganese oxide such as $Mn_2O_3$, $MnO_2$, and $Mn_3O_4$, a manganese salt such as $MnCO_3$, $Mn(NO_3)_2$, $MnSO_4$, manganese acetate, dicarboxylic acid manganese, citric acid manganese, and fatty acid manganese salt, manganese oxyhydroxide, manganese chloride, or a combination thereof, but is not limited thereto.

The aluminum-containing raw material may be, for example, $Al_2O_3$, $Al(OH)_3$, $Al(NO_3)_3$, $Al_2(SO_4)_3$, $(HO)_2AlCH_3CO_2$, $HOAl(CH_3CO_2)_2$, $Al(CH_3CO_2)_3$, an aluminum halide, or a combination thereof, but is not limited thereto.

The transition metal-containing solution may be prepared by adding the nickel-containing raw material, the cobalt-containing raw material, the manganese-containing raw material, and the aluminum-containing raw material to a solvent, specifically water, or a mixed solvent of water and an organic solvent which can be uniformly mixed with water (for example, an alcohol, etc.), or may be prepared by mixing an aqueous solution of the nickel-containing raw material, an aqueous solution of the cobalt-containing raw material, and the manganese-containing raw material.

The ammonium cation-containing complex forming agent may be, for example, $NH_4OH$, $(NH_4)_2SO_4$, $NH_4NO_3$, $NH_4Cl$, $CH_3COONH_4$, $NH_4CO_3$, or a combination thereof, but is not limited thereto. Meanwhile, the ammonium cation-containing complex forming agent may be used in the form of an aqueous solution, and at this time, water, or a mixture of an organic solvent (for example, an alcohol, etc.) which can be uniformly mixed with water and water may be used as a solvent.

The basic compound may be a hydroxide of an alkali metal or an alkaline earth metal, such as $NaOH$, $KOH$ or $Ca(OH)_2$, a hydrate thereof, or a combination thereof. The basic compound may also be used in the form of an aqueous solution, and at this time, as a solvent, water, or a mixture of an organic solvent (for example, alcohol, etc.) which can be uniformly mixed with water and water may be used.

The basic compound is added to control the pH of a reaction solution, and may be added in an amount such that the pH of a metal solution is 8 to 12.

The coprecipitation reaction may be performed in an inert atmosphere, for example, in a nitrogen atmosphere, an argon atmosphere, or the like, at a temperature in the range of 35 °C to 80 °C.

By the above-described process, positive electrode active material precursor particles of a nickel-cobalt-manganese hydroxide, or nickel-cobalt-manganese-aluminum hydroxide are generated and precipitated in the reaction solution. By controlling the concentration of the nickel-containing raw material, the cobalt-containing raw material, the manganese-containing raw material, and the aluminum-containing raw material, it is possible to prepare a positive electrode active material precursor having a nickel (Ni) content of 55 mol% or greater in the total content of metals. The precipitated positive electrode active material precursor particles are separated according to a typical method, and dried to prepare a positive electrode active material precursor.

The lithium raw material may be a sulfate, a nitrate, an acetate, a carbonate, an oxalate, a citrate, a halide, a hydroxide, an oxyhydroxide, or the like, which contains lithium, and is not particularly limited as long as it may be dissolved in water. Specifically, the lithium raw material may be $Li_2CO_3$, $LiNO_3$, $LiNO_2$, $LiOH$, $LiOH \cdot H_2O$, $LiH$, $LiF$, $LiCl$, $LiBr$, $LiI$, $CH_3COOLi$, $Li_2O$, $Li_2SO_4$, $CH3COOLi$, $Li_3C_6H_5O_7$, or the like, and any one thereof or a mixture of two or more thereof may be used.

The mixing may be performed by solid-phase mixing or liquid-phase mixing. If components are mixed through solid-phase mixing, a firing process may be performed without a separate drying process, and if components are mixed through liquid-phase mixing, a firing process is performed after spray-drying the mixed components.

In addition, if necessary, a doping raw material may be further mixed.

As the doping raw material, an oxide, a hydroxide, a sulfide, an oxyhydroxide, a halide, or a mixture thereof including one or more elements selected from the group consisting of Ti, Mg, Al, Zr, Y, Ba, Ca, Sr, W, Ta, Nb, and Mo may be used.

The primary firing may be performed under an air or oxygen atmosphere.

The primary firing may be performed at a temperature of 850 °C to 960 °C, preferably 860 °C to 960 °C, and more preferably 870 °C to 960 °C. By performing the firing in the above-described temperature range, it is possible to prepare positive electrode material powder having improved crystallinity, thereby having improved structural stability, and by controlling the area of a grain as measured on a cross-section of an electrode manufactured by applying the positive electrode material powder to an appropriate value, it is possible to obtain an appropriate single crystallinity.

In addition, the primary firing may be performed for 10 hours to 20 hours, preferably 10 hours to 18 hours, and more preferably 10 hours to 15 hours. If the firing time is less than 10 hours, the crystallinity is inferior, resulting in degrading structural stability, and the particle growth is not sufficient achieved, resulting in low single crystallinity. In addition, if the firing time is more than 20 hours, output properties of a battery is degraded due to over-firing.

(Step S2)

The method includes performing secondary firing on a fired product obtained by the primary firing, and the secondary firing sequentially includes a first maintaining period maintained at 720 °C to 850 °C, a second maintaining period maintained at 900 °C to 970 °C, and a third maintaining period maintained at 720 °C to 850 °C. The firing may be performed under an air or oxygen atmosphere.

The secondary firing includes the second maintaining period maintained at a higher temperature than the first maintaining period and the third maintaining period, and thus, may appropriately control the single crystallinity of the positive electrode material powder. Specifically, by including the second maintaining period for performing heat treatment for a short period of time at a higher temperature than the first maintaining period and the third maintaining period, it is possible to increase the single crystallinity of particles in which particle growth is non-uniform due to an insufficient amount of heat, so that it is possible to prepare positive electrode material powder having an appropriate single crystallinity. In addition, if the first to third maintaining periods are included in the primary firing, not the secondary firing, it may be difficult to obtain an appropriate single crystallinity.

The temperature of the first maintaining period and the temperature of the third maintaining period may each independently be 720 °C to 850 °C, preferably 730 °C to 840 °C, or more preferably 750 °C to 830 °C, and the temperature of the first maintaining period and the temperature of the third maintaining period may be the same. If the above-described range is satisfied, high-temperature lifespan and high-temperature storage performance may be improved due to excellent surface structure stability, and capacity properties, output properties, and high-temperature lifespan properties of a battery may be improved due to less particle agglomeration.

The temperature of the second maintenance section may be 900 °C to 970 °C, preferably 910 °C to 960 °C, and more preferably 920 °C to 950 °C. If the above-described range is satisfied, it is possible to grow particles with a sufficient amount of heat, thereby solving the problem of non-uniform particle growth due to a low amount of heat, so that high-temperature lifespan properties and high-temperature storage properties of a battery may be improved.

The first maintaining period may be maintained from 5 hours to 10 hours, preferably from 6 hours to 10 hours, or more preferably from 7 hours to 9 hours. If the above-described range is satisfied, particles may be aggregated in an appropriate number, so that a desired range of single crystallinity may be satisfied.

The second maintaining period may be maintained from 5 minutes to 60 minutes, preferably from 10 minutes to 50 minutes, or more preferably from 10 minutes to 40 minutes. If the above-described range is satisfied, the problem of non-uniform particle growth may be solved, so that an appropriate range of single crystallinity may be satisfied.

The third maintaining period may be maintained from 5 hours to 10 hours, preferably from 6 hours to 10 hours, or more preferably from 7 hours to 9 hours. If the above-described range is satisfied, particles may be aggregated in an appropriate number, so that a desired range of single crystallinity may be satisfied.

The total firing time of the secondary firing may be 10 hours to 15 hours, preferably 10 hours to 14 hours, or more preferably 10 hours to 13 hours. If the above-described range is satisfied, surface structure stabilization may be sufficiently achieved, thereby improving surface structure durability, and particles are not excessively aggregated with each other, so that electrochemical properties of a battery may be improved.

If necessary, a fired product subjected to the secondary firing and a coating raw material may be mixed and heat-treated to form a coating layer.

The formation of the coating layer may be performed by a method known in the art. For example, a wet coating method, a dry coating method, a plasma coating method, Atomic Ayer Deposition (ALD) or the like may be used.

The wet coating method may be performed by, for example, adding an appropriate solvent such as ethanol, water, methanol, acetone, or the like to a fired product subjected to the secondary firing and a coating raw material, and then mixing the mixture until the solvent disappears.

The drying coating method is a method of mixing a lithium composite transition metal oxide and a coating raw material in a solid phase without a solvent, and for example, a grinder mixing method or a mechanofusion method may be used.

The coating raw material may be an oxide, a hydroxide, an oxyhydroxide, a carbonate, a sulfate, a halide, a sulfide, an acetate, a carboxylate, or a combination thereof including one or more elements selected from the group consisting of Ti, Mg, Al, Zr, Y, Ba, Ca, Zr, Sr, W, Ta, Nb, and Mo.

**Positive electrode**

Next, a positive electrode according to the present invention will be described.

The positive electrode according to the present invention includes a positive electrode active material layer including the positive electrode material powder according to the present invention. Specifically, the positive electrode includes a positive electrode current collector and a positive electrode active material layer formed on the positive electrode current collector and including the positive electrode material powder. Since the positive electrode material powder has been described above, the description of the positive electrode material powder will be omitted, and hereinafter, components excluding the positive electrode material powder will be described.

In the positive electrode, the positive electrode current collector is not particularly limited as long as it has conductivity without causing a chemical change in the battery, and for example, stainless steel, aluminum, nickel, titanium, fired carbon, or aluminum or stainless steel that is surface-treated with one of carbon, nickel, titanium, silver, and the like may be used. Also, the positive electrode current collector may typically have a thickness of 3 $\mu$m to 500 $\mu$m, and microscopic irregularities may be formed on the surface of the positive electrode current collector to improve the adhesion of the positive electrode active material. For example, the positive electrode current collector may be used in various forms such as a film, a sheet, a foil, a net, a porous body, a foam, and a non-woven body.

In addition, the positive electrode active material layer may include a conductive material and a binder, together with the positive electrode material powder described above.

The conductive material is used to impart conductivity to an electrode, and any conductive material may be used without particular limitation as long as it has electron conductivity without causing a chemical change in a battery to be constituted. Specific examples thereof may include graphite such as natural graphite or artificial graphite; a carbon-based material such as carbon black, acetylene black, Ketjen black, channel black, furnace black, lamp black, thermal black, carbon fiber, and a carbon nanotube; metal powder or metal fiber of such as copper, nickel, aluminum, and silver; a conductive whisker such as a zinc oxide whisker and a potassium titanate whisker; a conductive metal oxide such as a titanium oxide; or a conductive polymer such as a polyphenylene derivative, and any one thereof or a mixture of two or more thereof may be used. The conductive material may be typically included in an amount of 1 to 30 wt%, preferably 1 to 20 wt%, and more preferably 1 to 10 wt% based on the total weight of a positive electrode active material layer.

The binder serves to improve the bonding between positive electrode active material particles and the adhesion between the positive electrode active material and the positive electrode current collector. Specific examples thereof may include polyvinylidene fluoride (PVDF), a polyvinylidene fluoride-hexafluoropropylene copolymer (PVDF-co-HFP), polyvinyl alcohol, polyacrylonitrile, carboxymethyl cellulose (CMC), starch, hydroxypropyl cellulose, regenerated cellulose, polyvinylpyrrolidone, polytetrafluoroethylene, polyethylene, polypropylene, an ethylene-propylene-diene monomer (EPDM), a sulfonated EPDM, styrene-butadiene rubber (SBR), fluorine rubber, or various copolymers thereof, and any one thereof or a mixture of two or more thereof may be used. The binder may be included in an amount of 1 to 30 wt%, preferably 1 to 20 wt%, and more preferably 1 to 10 wt% based on the total weight of the positive electrode active material layer.

The positive electrode may be manufactured according to a typical method for manufacturing a positive electrode. For example, the positive electrode may be manufactured by mixing a positive electrode material, a binder, and/or a conductive material in a solvent to prepare a positive electrode slurry, and applying the positive electrode slurry on a positive electrode current collector, followed by drying and roll-pressing.

The solvent may be a solvent commonly used in the art, and may be dimethyl sulfoxide (DMSO), isopropyl alcohol, N-methylpyrrolidone (NMP), acetone, water, or the like, and any one thereof or a mixture of two or more thereof may be used. The solvent may be used in an amount sufficient to dissolve or disperse the positive electrode active material, the conductive material, and the binder in consideration of the application thickness and preparation yield of a slurry, and to allow the slurry to have a viscosity which may exhibit excellent thickness uniformity when applied for the manufacturing of the positive electrode later.

In another method, the positive electrode may be manufactured by casting the positive electrode slurry on a separate support and then laminating a film peeled off from the support on a positive electrode current collector.

## Lithium secondary battery

Next, the lithium secondary battery according to the present invention will be described.

The lithium secondary battery of the present invention includes the positive electrode according to the present invention, and specifically, includes a positive electrode including the positive electrode material powder according to the present invention. Specifically, the lithium secondary battery may include the positive electrode, a negative electrode, a separator, and an electrolyte, and more specifically, the lithium secondary battery may include a positive electrode, a negative electrode positioned to oppose the positive electrode, a separator interposed between the positive electrode and the negative electrode, and an electrolyte, wherein the positive electrode is the same as described above. Also, the lithium secondary battery may optionally further include a battery case for accommodating an electrode assembly of the positive electrode, the negative electrode, and the separator, and a sealing member for sealing the battery case.

(Negative electrode)

In the lithium secondary battery, the negative electrode includes a negative electrode current collector and a negative electrode active material layer positioned on the negative electrode current collector.

The negative electrode current collector is not particularly limited as long as it has high conductivity without causing a chemical change in a battery, and for example, copper, stainless steel, aluminum, nickel, titanium, fired carbon, copper or stainless steel that is surface-treated with one of carbon, nickel, titanium, silver, and the like, an aluminum-cadmium alloy, and the like may be used. Also, the negative electrode current collector may typically have a thickness of 3 $\mu$m to 500 $\mu$m, and as in the case of the positive electrode current collector, microscopic irregularities may be formed on the surface of the negative electrode current collector to improve the binding force of the negative electrode active material. For example, the negative electrode current collector may be used in various forms such as a film, a sheet, a foil, a net, a porous body, a foam, a non-woven body, and the like.

The negative electrode active material layer optionally includes a binder and a conductive material in addition to the negative electrode active material.

As the negative electrode active material, a compound capable of reversible intercalation and de-intercalation of lithium may be used. Specific examples thereof may include a carbonaceous material such as artificial graphite, natural graphite, graphitized carbon fiber, and amorphous carbon; a metallic compound alloyable with lithium such as Si, Al, Sn, Pb, Zn, Bi, In, Mg, Ga, Cd, an Si alloy, an Sn alloy, or an Al alloy; a metal oxide which may be doped and undoped with lithium such as $SiO_\beta(0<\beta< 2)$, $SnO_2$, a vanadium oxide, and a lithium vanadium oxide; or a composite including the metallic compound and the carbonaceous material such as an Si-C composite or an Sn-C composite, and any one thereof or a mixture of two or more thereof may be used.

Also, a metal lithium thin film may be used as the negative electrode active material. Also, low crystalline carbon, high crystalline carbon, and the like may all be used as a carbon material. Representative examples of the low crystalline carbon may include soft carbon and hard carbon, and representative examples of the high crystalline carbon may include irregular, planar, flaky, spherical, or fibrous natural graphite or artificial graphite, Kish graphite, liquid crystal pitch, mesophase pitch-based carbon fiber, meso-carbon microbeads, mesophase pitches, and high-temperature sintered carbon such as petroleum or coal tar pitch derived cokes.

The conductive material is used to impart conductivity to an electrode, and any conductive material may be used without particular limitation as long as it has electron conductivity without causing a chemical change in a battery to be constituted. Specific examples thereof may include graphite such as natural graphite or artificial graphite; a carbon-based material such as carbon black, acetylene black, Ketjen black, channel black, furnace black, lamp black, thermal black, carbon fiber, and a carbon nanotube; metal powder or metal fiber of such as copper, nickel, aluminum, and silver; a conductive whisker such as a zinc oxide whisker and a potassium titanate whisker; a conductive metal oxide such as a titanium oxide; or a conductive polymer such as a polyphenylene derivative, and any one thereof or a mixture of two or more thereof may be used. The conductive material may be typically included in an amount of 1 to 30 wt%, preferably 1 to 20 wt%, and more preferably 1 to 10 wt% based on the total weight of a negative electrode active material layer.

The binder serves to improve the bonding between negative electrode active material particles and the adhesion between the negative electrode active material and the negative electrode current collector. Specific examples thereof may include polyvinylidene fluoride (PVDF), a polyvinylidene fluoride-hexafluoropropylene copolymer (PVDF-co-HFP), polyvinyl alcohol, polyacrylonitrile, carboxymethyl cellulose (CMC), starch, hydroxypropyl cellulose, regenerated cellulose, polyvinylpyrrolidone, polytetrafluoroethylene, polyethylene, polypropylene, an ethylene-propylene-diene monomer (EPDM), a sulfonated EPDM, styrene-butadiene rubber (SBR), fluorine rubber, or various copolymers thereof, and any one thereof or a mixture of two or more thereof may be used. The binder may be included in an amount of 1 to 30 wt%, preferably 1 to 20 wt%, and more preferably 1 to 10 wt% based on the total weight of the negative electrode active material layer.

As an example, the negative electrode active material layer may be prepared by applying a negative electrode slurry including a negative electrode active material, and optionally a binder and a conductive material on a negative electrode current collector, followed by drying, or may be prepared by casting the negative electrode slurry on a separate support, and then laminating a film peeled off from the support on a negative electrode current collector.

(Separator)

Meanwhile, in the lithium secondary battery, the separator is to separate the negative electrode and the positive electrode and to provide a movement path for lithium ions, and any separator may be used without particular limitation as long as it is a separator commonly used in a lithium secondary battery, and particularly, a separator having high moisture-retention capability for an electrolyte solution while having low resistance to the movement of electrolyte ions is preferable. Specifically, a porous polymer film, for example, a porous polymer film manufactured using a polyolefin-based polymer such as an ethylene homopolymer, a propylene homopolymer, an ethylene/butene copolymer, an ethylene/hexene copolymer, or an ethylene/methacrylate copolymer, or a stacked structural body having two or more layers thereof may be used. In addition, a typical porous non-woven fabric, for example, a non-woven fabric made of glass fiber having a high melting point, polyethylene terephthalate fiber, or the like may be used. Also, a coated separator including a ceramic component or a polymer material may be used to secure heat resistance or mechanical strength, and may optionally be used in a single-layered or multi-layered structure.

(Electrolyte)

In addition, the electrolyte used in the present invention may be an organic liquid electrolyte, an inorganic liquid electrolyte, a solid polymer electrolyte, a gel-type polymer electrolyte, a solid inorganic electrolyte, a molten-type inorganic electrolyte, or the like, all of which may be used in the manufacturing of a lithium secondary battery, but the electrolyte is not limited thereto.

Specifically, the electrolyte may include an organic solvent and a lithium salt.

Any organic solvent may be used as the organic solvent without particular limitation as long as it may serve as a medium through which ions involved in an electrochemical reaction of the battery may move. Specifically, as the organic solvent, an ester-based solvent such as methyl acetate, ethyl acetate, $\gamma$-butyrolactone, or $\varepsilon$-caprolactone; an ether-based solvent such as dibutyl ether or tetrahydrofuran; a ketone-based solvent such as cyclohexanone; an aromatic hydrocarbon-based solvent such as benzene or fluorobenzene; a carbonate-based solvent such as dimethyl carbonate (DMC), diethyl carbonate (DEC), methylethyl carbonate (MEC), ethylmethyl carbonate (EMC), ethylene carbonate (EC), or propylene carbonate (PC); an alcohol-based solvent such as ethyl alcohol or isopropyl alcohol; nitriles such as R-CN (wherein R is a linear, branched, or cyclic C2 to C20 hydrocarbon group, and may include a double-bond aromatic ring or ether bond); amides such as dimethylformamide; dioxolanes such as 1,3-dioxolane; or sulfolanes may be used. Among these, the carbonate-based solvent is preferred, and a mixture of a cyclic carbonate (e.g., ethylene carbonate or propylene carbonate) having high ion conductivity and a high dielectric constant, which may increase charge/discharge performance of the battery, and a low-viscosity linear carbonate-based compound (e.g., ethylmethyl carbonate, dimethyl carbonate, diethyl carbonate, or the like) is more preferred.

As the lithium salt, any compound may be used without particular limitation as long as it can provide lithium ions used in a lithium secondary battery. Specifically, as the lithium salt, $LiPF_6$, $LiClO_4$, $LiAsF_6$, $LiBF_4$, $LiSbF_6$, $LiAlO_4$, $LiAlCl_4$, $LiCF_3SO_3$, $LiC_4F_9SO_3$, $LiN(C_2F_5SO_3)_2$, $LiN(C_2F_5SO_2)_2$, $LiN(CF_3SO_2)_2$, LiCl, LiI, $LiB(C_2O_4)_2$, or the like may be used. It is good that the lithium salt is used in a concentration range of 0.1 M to 5.0 M, preferably 0.1 M to 3.0 M. If the concentration of the lithium salt is included in the above-described range, the electrolyte has suitable conductivity and viscosity, and thus, may exhibit excellent electrolyte performance, and lithium ions may effectively move.

For purposes of improving the lifespan properties of a battery, suppressing the reduction in battery capacity, improving the discharge capacity of the battery, and the like, the electrolyte may additionally include an additive in addition to the above electrolyte components. For example, as the additive, a haloalkylene carbonate-based compound such as difluoroethylene carbonate or the like, pyridine, triethylphosphite, triethanolamine, cyclic ether, ethylene diamine, n-glyme, hexamethylphosphate triamide, a nitrobenzene derivative, sulfur, a quinone imine dye, N-substituted oxazolidinone, N,N-substituted imidazolidine, ethylene glycol dialkyl ether, ammonium salt, pyrrole, 2-methoxy ethanol, aluminum trichloride, or the like may be used alone or in combination, but the additive is not limited thereto. The additive may be included in an amount of 0.1 to 10 wt%, Preferably 0.1 to 5 wt% based on the total weight of the electrolyte.

As described above, a lithium secondary battery including the positive electrode material powder according to the present invention stably exhibits excellent discharge capacity, output properties, and capacity retention rate, and thus, is useful in the field of portable devices such as mobile phones, laptop computers, digital cameras, etc., and in the field of electric cars such as a hybrid electric vehicle (HEV).

Accordingly, according to another embodiment of the present invention, a battery module including the lithium secondary battery as a unit cell, and a battery pack including the battery module are provided.

The battery module or the battery pack may be used as a power source for one or more medium-to-large devices in a power tool, an electric car including an electric vehicle (EV), a hybrid electric vehicle, and a plug-in hybrid electric vehicle (PHEV), or a system for power storage.

Hereinafter, embodiments of the present invention will be described in detail so that those skilled in the art may easily carry out the present invention. However, the present invention may be embodied in many different forms, and is not limited to the embodiments set forth herein.

Example 1

Nickel-cobalt-manganese-aluminum hydroxide powder having a molar ratio of Ni : Co : Mn : Al of 85 : 7 : 6 : 2 and a lithium hydroxide were mixed such that the molar ratio of a transition metal (Ni+Co+Mn+Al) : Li was 1: 1.04, and then primary firing for firing the mixture at 950 °C for 12 hours was performed.

Thereafter, secondary firing was performed by sequentially performing a first maintaining period for maintaining a fired product obtained by the primary firing at 820 °C for 5 hours, a second maintaining period for maintaining the same at 950 °C for 10 minutes, and a third maintaining period for maintaining the same at 820 °C for 5 hours to prepare positive electrode material powder.

Example 2

Positive electrode material powder was prepared in the same manner as in Example 1, except that primary firing was performed at 870 °C for 12 hours, and secondary firing was performed by sequentially performing a first maintaining period for maintaining the fired mixture at 805 °C for 5 hours, a second maintaining period for maintaining the same at 950 °C for 10 minutes, and a third maintaining period for maintaining the same at 805 °C for 5 hours.

Comparative Example 1

Nickel-cobalt-manganese-aluminum hydroxide powder having a molar ratio of Ni : Co : Mn : Al of 85 : 7 : 6 : 2 and a lithium hydroxide were mixed such that the molar ratio of a transition metal (Ni+Co+Mn+Al) : Li was 1: 1.04, and then primary firing for firing the mixture at 830 °C for 22 hours was performed to prepare positive electrode material powder.

Comparative Example 2

Positive electrode material powder was prepared in the same manner as in Comparative Example 1, except that primary firing was performed at 950 °C for 20 hours.

Comparative Example 3

Nickel-cobalt-manganese-aluminum hydroxide powder having a molar ratio of Ni : Co : Mn : Al of 85 : 7 : 6 : 2 and a lithium hydroxide were mixed such that the molar ratio of a transition metal (Ni+Co+Mn+Al) : Li was 1: 1.04, and then primary firing for firing the mixture at 950 °C for 8 hours was performed, followed by firing the same at 800 °C for 8 hours to prepare positive electrode material powder.

Comparative Example 4

Positive electrode material powder was prepared in the same manner as in Comparative Example 3, except that primary firing was performed at 965 °C for 10 hours, and the firing was performed at 860 °C for 10 hours.

**Comparative Example 5**

Nickel-cobalt-manganese-aluminum hydroxide powder having a molar ratio of Ni : Co : Mn : Al of 85 : 7 : 6 : 2 and lithium hydroxide were mixed such that the molar ratio of a transition metal (Ni+Co+Mn+Al) : Li was 1: 1.04, and then firing was performed by maintaining the mixture at 920 °C for 8 hours, maintaining the same at 950 °C for 10 minutes, and then maintaining the same at 920 °C for 8 hours to prepare positive electrode material powder.

**Comparative Example 6**

Positive electrode material powder was prepared in the same manner as in Example 1, except that primary firing was performed at 950 °C for 12 hours, and secondary firing was performed by sequentially performing a first maintaining period for maintaining the fired mixture at 820 °C for 5 hours, a second maintaining period for maintaining the same at 990 °C for 5 minutes, and a third maintaining period for maintaining the same at 820 °C for 5 hours.

**Comparative Example 7**

Positive electrode material powder was prepared in the same manner as in Example 1, except that primary firing was performed at 950 °C for 12 hours, and secondary firing was performed by sequentially performing a first maintaining period for maintaining the fired mixture at 820 °C for 5 hours, a second maintaining period for maintaining the same at 890 °C for 20 minutes, and a third maintaining period for maintaining the same at 820 °C for 5 hours.

**Comparative Example 8**

Positive electrode material powder was prepared in the same manner as in Example 1, except that nickel-cobalt-manganese-aluminum hydroxide powder having a molar ratio of Ni : Co : Mn : Al of 75 : 5 : 18 : 2 and a lithium hydroxide were mixed such that the molar ratio of a transition metal (Ni+Co+Mn+Al) : Li was 1: 1.04.

The preparation methods of Examples 1 and 2 and Comparative Examples 1 to 8 above are summarized and shown in Table 1 below.

[Table 1]

| | | Example 1 | Example 2 | Comparative Example 1 | Comparative Example 2 | Comparative Example 3 | Comparative Example 4 | Comparative Example 5 | Comparative Example 6 | Comparative Example 7 | Comparative Example 8 |
|---|---|---|---|---|---|---|---|---|---|---|---|
| Firing recovery | | 2 times | 2 times | 1 times | 1 times | 2 times | 2 times | 1 times | 2 times | 2 times | 2 times |
| Firing temperature and time | First time | 950 °C/ 12 h | 870 °C/ 12 h | 830 °C/ 22 h | 950 °C/ 20 h | 950 °C/ 8 h | 965 °C/ 10 h | 920 °C/ 8 h | 950 °C/ 12 h | 950 °C/ 12 h | 950 °C/ 12 h |
| | | | | | | | | 950 °C/ 10 min | | | |
| | | | | | | | | 920 °C/ 8 h | | | |
| | Second time | 820 °C/ 5 h | 805 °C/ 5 h | - | - | 800 °C/ 8 h | 860 °C/ 10 h | - | 820 °C/ 5 h | 820 °C/ 5 h | 820 °C/ 5 h |
| | | 950 °C/ 10 min | 950 °C/ 10 min | | | | | | 990 °C/ 5 min | 890 °C/ 20 min | 950 °C/ 10 min |
| | | 820 °C/ 5 h | 805 °C/ 5 h | | | | | | 820 °C/ 5 h | 820 °C/ 5 h | 820 °C/ 5 h |

EP 4 752 974 A1

15

Experimental Example 1: Measurement of average particle diameter, BET specific surface area, particle breakage, and roll-pressing density

(Average particle diameter ($D_{50}$) measurement)

0.03 g of each of the positive electrode material powder prepared in Examples 1 and 2 and Comparative Examples 1 to 8 was dispersed in a dispersion medium, and then introduced into a commercially available laser diffraction particle size measuring device (Microtrac MT 3000), followed by irradiating ultrasound waves of about 28 kHz thereon to an output of 60W to measure the average particle diameter ($D_{50}$) of each of the positive electrode material powder. The measurement results are shown in Table 2 below.

(BET specific surface area measurement)

In addition, 3 g of the positive electrode material powder prepared by each of Examples 1 and 2 and Comparative Examples 1 to 8 was collected, and then measured by a BET method through BELSORP Co-mini II, and the measurement results are shown in Table 2 below.

(Particle breakage measurement)

In addition, 5 g of the positive electrode material powder prepared by each of Examples 1 and 2 and Comparative Examples 1 to 8 was placed in a cylindrical metal mold having a diameter of 4 cm, pressed at a pressure of 9 tons, and then a volume cumulative particle size distribution (PSD) was measured to measure the rate of generation of fine powder of 1 $\mu$m or less. For the total volume of the positive electrode material powder, the rate of generation of fine powder having a particle diameter of 1 $\mu$m or less was converted into vol% and is shown in Table 2.

(Roll-pressing density measurement)

In addition, the roll-pressing density was measured using HANTECH HLP-AC12-T. Specifically, 5 g of the positive electrode material powder prepared by each of Examples 1 and 2 and Comparative Examples 1 to 8 was placed in a cylindrical metal mold having a diameter of 4 cm, pressed at a pressure of 2 tons, and then the height of the pressed mold was measured by a vernier caliper to obtain a roll-pressing density, which is shown in Table 2.

**Experimental Example 2: EBSD analysis and single crystallinity measurement**

The positive electrode material powder prepared in each of Examples 1 and 2 and Comparative Examples 1 to 8, carbon black as a conductive material, polyvinylidene fluoride (PVdF) as a binder were mixed at a weight ratio 95 : 2.5 : 2.5 in N-methyl-pyrrolidone (NMP) to prepare an electrode slurry. The electrode slurry was applied on one surface of an aluminum current collector, and then dried at 130 °C to prepare an electrode for EBSD analysis. When manufacturing the positive electrode, roll-pressing was not performed.

Using an ion milling device (HITACHI IM-500, acceleration voltage of 6 kV), the positive electrode was cross-sectioned, and a SEM image was thereof obtained using FE-SEM (JEOL JSM7900F) equipment equipped with an electron backscatter diffraction (EBSD) analyzer, the SEM image was subjected to EBSD analysis. The EBSD analysis was performed on a scale with a total grain number of approximately 400+/- 10 under the conditions of an acceleration voltage of 15 kV and a W.D. of 15 mm.

Through the EBSD analysis, the area of each grain observed on each positive electrode cross-section was measured, and substituted into Equation (1) to calculate single crystallinity. The measurement results are shown in Table 2 below.

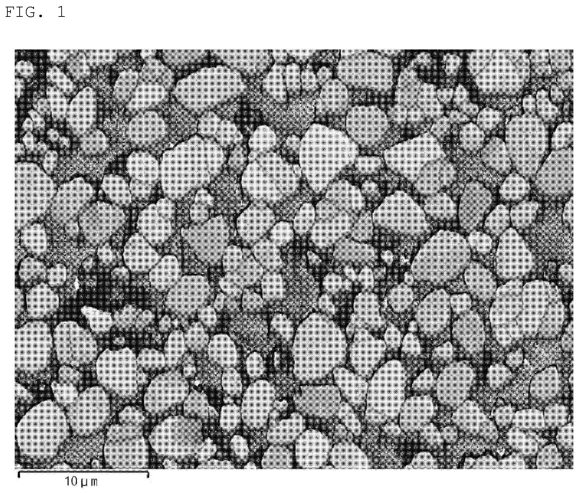

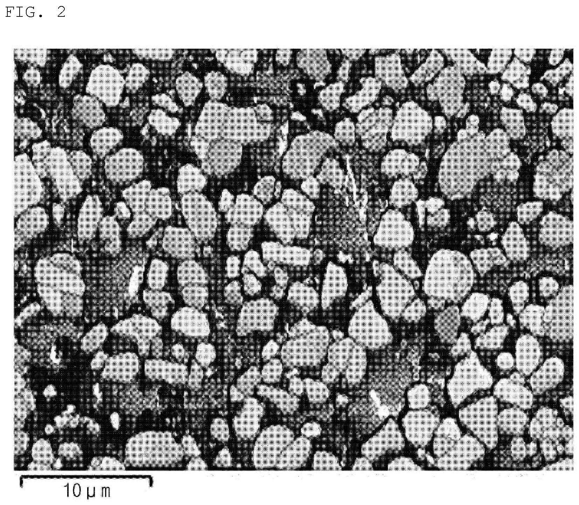

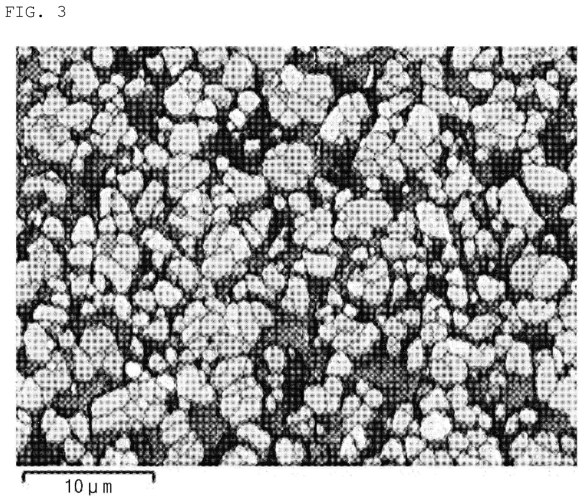

In addition, FIG. 1 to FIG. 3 illustrate SEM images of cross-sections of electrodes manufactured using the positive electrode material powder of Examples 1 and 2 and Comparative Example 2, and FIG. 4 to FIG. 6 illustrate EBSD analysis images of the cross-sections of the electrodes manufactured using the positive electrode material powder of Examples 1 and 2 and Comparative Example 2.

[Table 2]

| | Molar ratio of nickel among all metals except lithium in oxide | Particle shape | D50 (μm) | Specific surface area (m2/g) | Particle break age (vol%) | Roll - pressing density (g/cc) | Single crystallinity |
|---|---|---|---|---|---|---|---|
| Example 1 | 0.85 | Single particle or pseudo-single particle | 3.51 | 0.53 | 1. 65 | 3.05 | 2.45 |
| Example 2 | 0.85 | Single particle or pseudo-single particle | 3.56 | 0.68 | 2.88 | 2.98 | 2.04 |
| Comparative Example 1 | 0.85 | Secondary particle | 3.45 | 1.12 | 12.13 | 2.63 | - |
| Comparative Example 2 | 0.85 | Single particle or pseudo-single particle | 3.54 | 0.77 | 7.27 | 2.84 | 1. 67 |
| Comparative Example 3 | 0.85 | Single particle or pseudo-single particle | 3.24 | 0.74 | 0.36 | 2.88 | 1.78 |
| Comparative Example 4 | 0.85 | Single particle or pseudo-single particle | 4.01 | 0.45 | 0.12 | 3.11 | 3.21 |
| Comparative Example 5 | 0.85 | Single particle or pseudo-single particle | 3.47 | 0.80 | 7.61 | 2.79 | 1.62 |
| Comparative Example 6 | 0.85 | Single particle or pseudo-single particle | 4.05 | 0.47 | 0.11 | 3.13 | 3.24 |
| Comparative Example 7 | 0.85 | Single particle or pseudo-single particle | 3.28 | 0.71 | 6.55 | 2.92 | 1.81 |
| Comparative Example 8 | 0.75 | Single particle or pseudo-single particle | 2.8 | 1.00 | 15.8 | 2.45 | 1.1 |

As can be confirmed from Table 2 above, it can be seen that compared to Comparative Examples 1 to 8, Examples 1 and 2 satisfy the above-described single crystallinity.

**<Manufacturing of lithium secondary battery>**

The positive electrode material powder prepared in each of Examples 1 and 2 and Comparative Examples 1 to 8, carbon black as a conductive material, polyvinylidene fluoride (PVDF) as a binder were mixed at a weight ratio of 95 : 2.5 : 2.5 in N-methyl-2-pyrrolidone (NMP) to prepare a positive electrode slurry. The positive electrode slurry was applied on one surface of an aluminum current collector, dried at 130°C, and then roll-pressed to manufacture a positive electrode.

Artificial graphite as a negative electrode active material, carbon black as a conductive material, and SBR-CMC as a binder were mixed at a weight ratio of 95 : 3.5 : 1.5 to prepare a negative electrode slurry, and the negative electrode slurry was applied on one surface of a copper current collector, dried at 100°C, and then roll-pressed to manufacture a negative electrode.

A separator was interposed between the positive electrode and the negative electrode to manufacture an electrode assembly, and the electrode assembly was placed inside a battery case, followed by injecting an electrolyte solution into the case to manufacture a lithium secondary battery. The electrolyte solution was an electrolyte solution prepared by dissolving 1 M of $LiPF_6$ in a mixed organic solvent in which ethylene carbonate (EC) and ethylmethyl carbonate (EMC) were mixed at a volume ratio of 1:2.

### Experimental Example 3: Evaluation of high-temperature storage properties

Each of the lithium secondary batteries manufactured as described above was charged to 4.2 V with 0.5 C in a CC-CV mode, and then the secondary battery was dissembled to separate the positive electrode. Then, the positive electrode and 200 $\mu\ell$ of an electrolyte solution were put into a pouch-type battery case, and the battery case was sealed to manufacture a cell, and the cell was stored at 65 °C for 8 weeks to measure the change in cell volume ($\Delta$Cell volume, unit: $\Delta$mL) before and after the high-temperature storage. The cell volume change was measured by placing the cell in water and then measuring the volume change of the water. The measurement results are shown in Table 3.

### Experimental Example 4: Evaluation of high-temperature lifespan properties

Each of the lithium secondary batteries manufactured as described above was charged to 4.2 V with 1 C in a CC-CV mode at 45°C, and discharged to 2.5 V with a constant current of 2 C, which was set to one cycle, and then 100 cycles of the charging and discharging were performed to measure a capacity retention rate so as to evaluate high-temperature lifespan properties. The measurement results are shown in Table 3.

[Table 3]

|  | Change in cell volume after 8 weeks of high-temperature storage | Capacity retention rate (%) |
|---|---|---|
| Example 1 | 0.25 | 97.8 |
| Example 2 | 0.39 | 95.4 |
| Comparative Example 1 | 0.78 | 88.1 |
| Comparative Example 2 | 0.48 | 92.6 |
| Comparative Example 3 | 0.43 | 93.5 |
| Comparative Example 4 | 0.22 | 90.3 |
| Comparative Example 5 | 0.51 | 91.3 |
| Comparative Example 6 | 0.21 | 88.8 |
| Comparative Example 7 | 0.41 | 93.9 |
| Comparative Example 8 | 0.97 | 84.2 |

From Table 3 above, it can be confirmed that batteries to which the positive electrode material powder of Examples 1 and 2, in which the single crystallinity of Equation (1) satisfies the range of the invention, was applied, are superior in high-temperature lifespan properties and high-temperature storage properties to batteries to which the positive electrode material powder of Comparative Examples 1 to 8 was applied.

### Claims

1. Positive electrode material powder comprising lithium nickel-based oxide particles represented by Formula 1 below, and having a single crystallinity of 1.85 to 3.00 represented by Equation (1) below:

[Formula 1]    $Li_aNi_bCo_cM^1_dM^2O_2$

wherein in Formula 1 above, $M^1$ is Mn, Al, or a combination thereof, $M^2$ is one or more selected from the group consisting of Ti, Mg, Al, Zr, Y, Ba, Ca, Sr, W, Ta, Nb, and Mo, and $0.80 \leq a \leq 1.20$, $0.80 \leq b < 1$, $0 < c < 0.45$, $0 < d < 0.45$, and $0 \leq e \leq 0.20$:

$$\text{Equation (1): Single crystallinity} = \frac{\sum_{k=1}^{n} A_k^2}{\sum_{k=1}^{n} A_k}$$

wherein in Equation (1) above, $A_k$ is the area of a k-th grain as measured by ion-milling an electrode manufactured by applying the positive electrode material powder, and then analyzing a cross-section of the electrode by electron backscatter diffraction (EBSD), and n is the total number of grains as measured by the electron backscatter diffraction (EBSD) analysis, which is 200 to 500.

2. The positive electrode material powder of claim 1, wherein Formula 1 above is represented by Formula 1-1 below:

[Formula 1-1]     $Li_{a1}Ni_{b1}Co_{c1}Mn_{d1}Al_{d2}M^2_{e1}O_2$

wherein in Formula 1-1 above, $M^2$ is one or more selected from the group consisting of Ti, Mg, Al, Zr, Y, Ba, Ca, Sr, W, Ta, Nb, and Mo, and $0.85 \leq a1 \leq 1.20$, $0.80 \leq b1 < 1$, $0 < c1 < 0.18$, $0 < d1 < 0.18$, $0 < d2 < 0.15$, $0 \leq e1 \leq 0.20$, and $0 < d1 + d2 < 0.33$.

3. The positive electrode material powder of claim 1, wherein the positive electrode material powder has a specific surface area of $0.40 \text{ m}^2/\text{g}$ to $0.75 \text{ m}^2/\text{g}$.

4. The positive electrode material powder of claim 1, wherein the positive electrode material powder has a rollpressing density of 2.9 g/cc to 3.2 g/cc.

5. The positive electrode material powder of claim 1, wherein when the positive electrode material powder is pressed at 9 ton, the rate of generation of fine powder of 1 $\mu$m or less is 6 vol% or less.

6. The positive electrode material powder of claim 1, wherein the positive electrode material powder has an average particle diameter ($D_{50}$) of 2 um to 5 $\mu$m.

7. The positive electrode material powder of claim 1, wherein the positive electrode material powder has a single crystallinity of 2.0 to 2.5 represented by Equation (1).

8. A method for preparing the positive electrode material powder of claim 1, the method comprising:

(S1) mixing a positive electrode active material precursor and a lithium source, and then performing primary firing on the mixture; and
(S2) performing secondary firing on a fired product obtained by the primary firing,
wherein:

the primary firing is performed at 850 °C to 960 °C for 10 hours to 20 hours;
the secondary firing sequentially includes a first maintaining period maintained at 720 °C to 850 °C, a second maintaining period maintained at 900 °C to 970 °C, and a third maintaining period maintained at 720 °C to 850 °C; and
the positive electrode active material precursor has a nickel content of 80 mol% or greater among all metals excluding lithium.

9. The method of claim 8, wherein the primary firing is performed at 870 °C to 960 °C for 10 hours to 15 hours.

10. The method of claim 8, wherein the first maintaining period and the third maintaining period are independently maintained for 5 hours to 10 hours.

11. The method of claim 8, wherein the second maintaining period is maintained for 5 minutes to 60 minutes.

12. The method of claim 8, wherein the total firing time of the secondary firing is 10 hours to 15 hours.

13. A lithium secondary battery comprising:

a positive electrode including the positive electrode material powder of claim 1;
a negative electrode;
a separator; and
an electrolyte.

FIG. 1

10 μm

FIG. 2

10 μm

FIG. 3

10 μm

FIG. 4

FIG. 5

FIG. 6

## INTERNATIONAL SEARCH REPORT

| International application No. |
|---|
| **PCT/KR2024/013941** |

**A. CLASSIFICATION OF SUBJECT MATTER**

**H01M 4/525**(2010.01)i; **H01M 4/62**(2006.01)i; **H01M 10/052**(2010.01)i; **C30B 29/22**(2006.01)i; **C01G 53/00**(2006.01)i; **H01M 4/02**(2006.01)i

According to International Patent Classification (IPC) or to both national classification and IPC

**B. FIELDS SEARCHED**

Minimum documentation searched (classification system followed by classification symbols)

H01M 4/525(2010.01); C01G 53/00(2006.01); H01M 10/052(2010.01); H01M 10/0525(2010.01); H01M 4/131(2010.01); H01M 4/505(2010.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 리튬 이차전지(lithium secondary battery), 양극재(cathode material), 니켈 (nickel), 단결정(single crystal), 소성(sinter), 온도(temperature), 시간(time)

**C. DOCUMENTS CONSIDERED TO BE RELEVANT**

| Category* | Citation of document, with indication, where appropriate, of the relevant passages | Relevant to claim No. |
|---|---|---|
| A | KR 10-2023-0033480 A (SAMSUNG SDI CO., LTD.) 08 March 2023 (2023-03-08)<br>See claims 24, 25 and 28; and paragraphs [0191]-[0195]. | 1-13 |
| A | KR 10-2023-0098502 A (BEIJING EASPRING MATERIAL TECHNOLOGY CO., LTD.) 04 July 2023 (2023-07-04)<br>See claims 1-10; and paragraphs [0153]-[0158]. | 1-13 |
| A | JP 2023-093583 A (NICHIA CHEMICAL INDUSTRY LTD.) 04 July 2023 (2023-07-04)<br>See claims 1-22; and paragraphs [0175]-[0184]. | 1-13 |
| A | KR 10-2023-0083152 A (TOP MATERIAL CO., LTD.) 09 June 2023 (2023-06-09)<br>See claims 1-22. | 1-13 |
| A | KR 10-2022-0163061 A (SAMSUNG SDI CO., LTD.) 09 December 2022 (2022-12-09)<br>See claims 1-19. | 1-13 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **19 December 2024** | **19 December 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
**Information on patent family members**

International application No.

**PCT/KR2024/013941**

| Patent document cited in search report | | | Publication date (day/month/year) | Patent family member(s) | | | Publication date (day/month/year) |
|---|---|---|---|---|---|---|---|
| KR | 10-2023-0033480 | A | 08 March 2023 | CN | 115732652 | A | 03 March 2023 |
| | | | | EP | 4144703 | A1 | 08 March 2023 |
| | | | | JP | 2023-036062 | A | 13 March 2023 |
| | | | | JP | 7498233 | B2 | 11 June 2024 |
| | | | | US | 2023-0082796 | A1 | 16 March 2023 |
| KR | 10-2023-0098502 | A | 04 July 2023 | CN | 114703544 | A | 05 July 2022 |
| | | | | CN | 114703544 | B | 14 July 2023 |
| | | | | EP | 4159897 | A1 | 05 April 2023 |
| | | | | EP | 4159897 | A4 | 13 December 2023 |
| | | | | JP | 2023-540162 | A | 22 September 2023 |
| | | | | JP | 7398015 | B2 | 13 December 2023 |
| | | | | KR | 10-2669854 | B1 | 27 May 2024 |
| | | | | US | 2023-0202866 | A1 | 29 June 2023 |
| | | | | WO | 2022-207008 | A1 | 06 October 2022 |
| JP | 2023-093583 | A | 04 July 2023 | JP | 2017-188444 | A | 12 October 2017 |
| | | | | JP | 2018-125305 | A | 09 August 2018 |
| | | | | JP | 2022-009263 | A | 14 January 2022 |
| | | | | JP | 6341313 | B2 | 13 June 2018 |
| | | | | JP | 6966704 | B2 | 17 November 2021 |
| | | | | JP | 7265194 | B2 | 26 April 2023 |
| | | | | US | 11239464 | B2 | 01 February 2022 |
| | | | | US | 11728483 | B2 | 15 August 2023 |
| | | | | US | 2020-0106098 | A1 | 02 April 2020 |
| | | | | US | 2022-0112095 | A1 | 14 April 2022 |
| | | | | US | 2023-0352681 | A1 | 02 November 2023 |
| KR | 10-2023-0083152 | A | 09 June 2023 | KR | 10-2562808 | B1 | 02 August 2023 |
| KR | 10-2022-0163061 | A | 09 December 2022 | CN | 115440948 | A | 06 December 2022 |
| | | | | EP | 4098626 | A1 | 07 December 2022 |
| | | | | US | 2022-0388865 | A1 | 08 December 2022 |

Form PCT/ISA/210 (patent family annex) (July 2022)

28

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230124865